# EUROPEAN PATENT APPLICATION

(11) **EP 2 549 530 A1**
(43) Date of publication of application: **23.01.2013**
(21) Application number: 11800115.5
(22) Date of filing: 03.06.2011
(51) Int. Cl.: H01L 23/488

(54) **METHOD FOR ENHANCINGCHIP SPOT WELD RELIABILITY, PRINTED CIRCUIT BOARD AND ELECTRON DEVICE**

(30) Priority: 28.06.2010 CN 201010213052
(71) Applicant: Huawei Device Co., Ltd., Shenzhen, Guangdong 518129 (CN)
(72) Inventor: LU, David, Shenzhen Guangdong 518129 (CN)
(74) Representative: Thun, Clemens
(86) International application number: PCT/CN2011/075322
(87) International publication number: WO 2012/000370

(57) **Abstract**

The present invention relates to processing of PCBA, and provides a method for enhancing reliability of a welding spot of a chip, a printed circuit board and an electronic device. The method for enhancing reliability of the welding spot of the chip includes: dipping an epoxy flux on a weld leg of a chip or coating, with epoxy flux, a bonding pad corresponding to the weld leg of the chip, and mounting the chip to the bonding pad; and performing reflow processing on the bonding pad mounted with the chip, and finishing curing the epoxy flux. By applying the present invention, an Underfill process is not required, thereby reducing the cost of the device and improving the manufacturing efficiency.

## Description

This application claims priority to Chinese Patent Application No. 201010213052.9, filed with the Chinese Patent Office on June 28, 2010 and entitled "METHOD FOR ENHANCING RELIABILITY OF WELDING SPOT OF CHIP, PRINTED CIRCUIT BOARD AND ELECTRONIC DEVICE", which is incorporated herein by reference in its entirety.

### FIELD OF THE INVENTION

The present invention relates to processing of a printed circuit board assembly (PCBA, Printed Circuit Board Assembly), and in particular to a method for enhancing reliability of a welding spot of a chip, a printed circuit board and an electronic device.

### BACKGROUND OF THE INVENTION

Multi-functionalization and miniaturization become main development trends and technical demands of a personal consumption electronic product such as a cell phone or a wireless network card. Therefore, to enhance product functions and reduce a product size, a manufacturer of a consumption electronic chip enables chip scale packaging (CSP, Chip Scale Packaging) with a 0.50 millimeter (mm, millimeter) pitch (pitch) to be developed towards CSP with a 0.40 mm pitch or even 0.30 mm pitch, and meanwhile introduces a three-dimensional assembly process such as package on package (POP, Package On Package) chip stacking technologies to improve a layout density of the PCBA through a three-dimensional space. Then, the thickness of a printed circuit board (PCB, Printed Circuit Board) is changed from 1.20 mm and 1.0 mm towards 0.80 mm or even 0.60 mm, so as to meet the demand of miniaturization. The density improvement of a chip layout, the size reduction of solder balls and thinning of a PCB result in the declining of PCBA assembly strength, which presents a new challenge for a high-density surface mounted technology (SMT, Surface Mounted Technology) assembly process and reliability of a welding spot. Especially for a product such as a cell phone, the product usually suffers an impact of a mechanical stress due to falling, rolling or vibration during daily use, so there are high requirements on the mechanical reliability of the welding spot of a ball grid array (ball grid array, Ball Grid Array)/CSP-kind chip, and the reliability of the welding spot needs to be enhanced by some technical solutions.

An existing method for enhancing the reliability of the welding spot of the chip is as follows: a bottom portion of the chip is filled with Underfill (Underfill) glue after SMT, so that a gap between the chip and the PCB is full of the Underfill glue, and then the impact of the mechanical stress on the welding spot is eased through epoxy contained in the Underfill glue. An Underfill process is an independent process. Generally, after solder paste printing, device mounting and a reflow process, an online or offline dispensing device and a curing device preheat, dispense and cure the Underfill glue, so an Underfill preheating device, an Underfill dispensing device and an Underfill curing device are required, where the Underfill dispensing device mainly includes a manual operation type and a semi-automatic type. Therefore, an existing method for enhancing the reliability of the welding spot of the chip mainly includes: printing the solder paste, mounting the chip, reflow-soldering, preheating and dispensing the Underfill glue, and curing the Underfill glue.

Meanwhile, the current solder paste printing manner cannot meet the demands of high-density printing for the CSP chip with 0.30 mm pitch, so a Dipping Flux technical solution is used; and moreover, due to a reliability requirement, an Underfill protection solution needs to be further used after the Dipping Flux solution.

During the research of the prior art, the inventors find that, the existing methods for enhancing the reliability of the welding spot of the chip all need the Underfill process, while the Underfill process is incompatible with the SMT process, and therefore, in order to implement the Underfill process, it is required to add devices related to the Underfill process after the PCBA processing, which not only increases the cost investment of the device, but also increases the process procedures and reduces the manufacturing efficiency.

### SUMMARY OF THE INVENTION

Embodiments of the present invention provide a method for enhancing reliability of a welding spot of a chip, a printed circuit board and an electronic device, which do not need to use an Underfill process, thereby reducing the cost investment of the device and improving the manufacturing efficiency.

An embodiment of the present invention provides a method for enhancing reliability of a welding spot of a chip, where the method includes:
dipping an epoxy flux on a weld leg of a chip or coating, with the epoxy flux, a bonding pad corresponding to the weld leg of the chip, and mounting the chip on the bonding pad; and
performing reflow processing on the bonding pad mounted with the chip, and finishing curing the epoxy flux.

An embodiment of the present invention provides another method for enhancing reliability of a welding spot of a chip, where the method includes:
printing a solder paste on a printed circuit board, where the solder paste includes an epoxy component;
mounting a chip on the printed circuit board printed with the solder paste; and
performing reflow processing on the printed circuit board printed with the solder paste and mounted with the chip, and finishing curing the epoxy.

An embodiment of the present invention provides a printed circuit board, including a chip, where an outer portion of a welding spot of the chip on the printed circuit board and a lower half portion of the chip are both covered by an epoxy protection layer.

An embodiment of the present invention provides another printed circuit board, including a chip, where a welding spot between the chip and the printed circuit board includes a solder ball and an epoxy protection layer which is formed on a surface of the solder ball.

An embodiment of the present invention provides another printed circuit board, including a chip, where the chip is welded on the printed circuit board through the method for enhancing the reliability of the welding spot of the chip according to the embodiment of the present invention.

An embodiment of the present invention provides an electronic device, including a printed circuit board, where the printed circuit board includes a chip, and an outer portion of a welding spot of the chip on the printed circuit board and a lower half portion of the chip are both covered by an epoxy protection layer.

An embodiment of the present invention provides another electronic device, including a printed circuit board, where the printed circuit board includes a chip, a welding spot between the chip and the printed circuit board includes a solder ball and an epoxy protection layer which is formed on a surface of the solder ball.

An embodiment of the present invention provides another electronic device, including a printed circuit board, where the printed circuit board includes a chip, and the chip is welded on the printed circuit board through the method for enhancing the reliability of the welding spot of the chip according to the embodiment of the present invention.

It may be seen from the above technical solutions provided by the embodiments of the present invention that, in the embodiments of the present invention, the epoxy flux (Epoxy Flux) is used to replace a common Flux, and the Epoxy Flux includes an epoxy component, so an epoxy protection layer is formed around the welding spot after the completion of the welding. Therefore, when the welding spot suffers a mechanical impact, a mechanical stress may be eased and a mechanical strength of the welding spot may be improved. In this way, it is not required to use an Underfill process, and then Underfill devices are not required to be equipped with, thereby reducing cost investment of the device, and further decreasing the process procedures and improving the manufacturing efficiency as the Underfill process does not need to be used.

### BRIEF DESCRIPTION OF THE DRAWINGS

To illustrate the technical solutions according to the embodiments of the present invention more clearly, the accompanying drawings for describing the embodiments are introduced briefly in the following. Apparently, the accompanying drawings in the following description are some embodiments of the present invention, and persons skilled in the art may derive other drawings from the accompanying drawings without creative efforts.
FIG. 1 is a flow chart of a method for enhancing reliability of a welding spot of a chip provided by an embodiment of the present invention;
FIG. 2 is a schematic structural diagram of a welding spot of a chip on a PCB in an embodiment of the present invention;
FIG. 3 is a flow chart of a method for enhancing reliability of a welding spot of a chip provided by another embodiment of the present invention;
FIG. 4 is a flow chart of a method for enhancing reliability of a welding spot of a chip provided by another embodiment of the present invention;
FIG. 5 is a schematic structural diagram of a welding spot of a chip on a PCB in an embodiment of the present invention; and
FIG. 6 is a schematic structural diagram of a welding spot in an embodiment of the present invention.

### DETAILED DESCRIPTION OF THE EMBODIMENTS

The technical solution of the present invention is to be clearly and completely described in the following with reference to the accompanying drawings. It is obvious that the embodiments to be described are a part rather than all of the embodiments of the present invention. All other embodiments obtained by persons skilled in the art based on the embodiments of the present invention without creative efforts shall fall within the protection scope of the present invention.

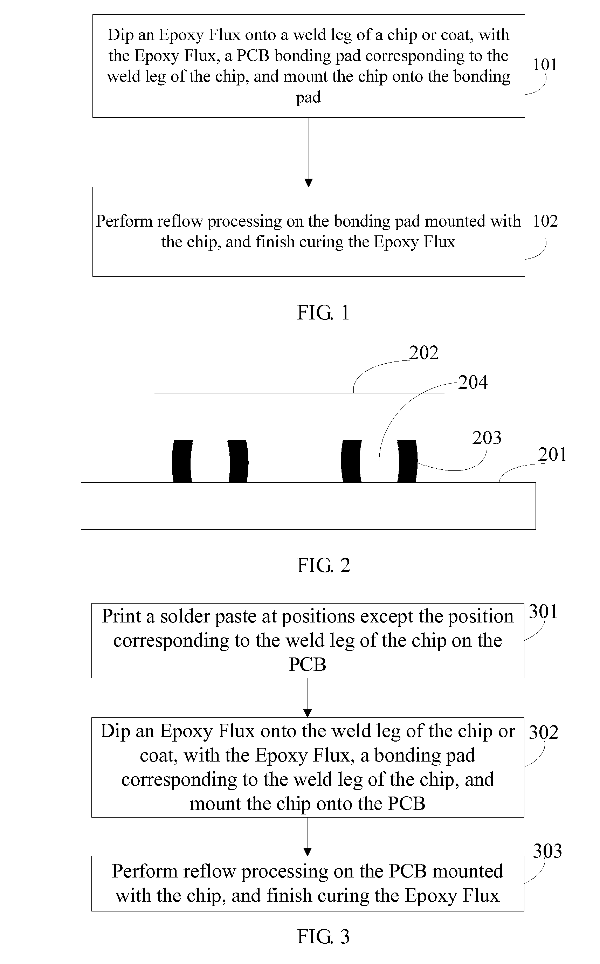

A method for enhancing reliability of a welding spot of a chip provided by an embodiment of the present invention is first introduced. FIG. 1 illustrates a procedure of a method for enhancing reliability of a welding spot of a chip provided by an embodiment of the present invention, and this embodiment describes a procedure of enhancing reliability of a welding spot of a top-layer chip in a POP process procedure, which includes the following steps:
Step 101: Dip an Epoxy Flux on a weld leg of a chip or coat, with the Epoxy flux, a PCB bonding pad corresponding to the weld leg of the chip, and mount the chip on the bonding pad.

The Epoxy Flux is a composite material, including a Flux for removing an OSP film or an oxide layer of the bonding pad, conducting heat, and assisting a solder ball in wetting and spreading for welding, and further including an epoxy component, so that an epoxy protection layer is formed around the welding spot after the completion of the welding, and when the welding spot suffers a mechanical compact, a mechanical stress is eased and a mechanical strength of the welding spot is improved. The chip may be specifically a ball grid array packaging chip, a CSP chip, or any chip requiring enhancement of mechanical reliability of a welding spot.

Dipping the Epoxy Flux on the weld leg of the chip may adopt a dipping (Dipping) manner, and the coating, with the Epoxy flux, the PCB bonding pad corresponding to the weld leg of the chip may adopt a jetting (Jetting) manner or a dispensing (Dispensing) manner.

The bonding pad may be located on a bottom-layer chip in the POP process procedure.

Step 102: Perform reflow processing on the bonding pad mounted with the chip, and finish curing the Epoxy flux.

The condition of curing the Epoxy Flux is the same as the condition of the solder paste reflow, so the Epoxy Flux may be cured at the same time when the reflow processing is performed on the bonding pad.

FIG. 2 illustrates a structure of a welding spot of a chip on a PCB after using the technical solution provided by this embodiment. As shown in FIG. 2, a chip 202 has two welding spots 204 on a PCB 201, and an outer portion of each welding spot 204 is covered by an epoxy protection layer 203.

It can be seen from the above that, in this embodiment, the Epoxy Flux is used to replace a common Flux, and the Epoxy Flux includes an epoxy component, so an epoxy protection layer may be formed around the welding spot after the completion of the welding. Therefore, when the welding spot suffers a mechanical impact, a mechanical stress may be eased and a mechanical strength of the welding spot may be improved. In this way, it is not required to use an Underfill process, and then it is also not required to equip Underfill devices, thereby reducing cost investment of the device, and further reducing the process procedures and improving the manufacturing efficiency as the Underfill process does not need to be used. Meanwhile, it is merely required to form the epoxy protection layer around the welding spot, so it is merely required to use the Epoxy Flux at a position of the weld leg, which belongs to a point-to-point technical solution, and may save the material and reduce the cost in comparison with the Underfill process in which Underfill glue needs to be fully filled between the bonding pad and the chip. Meanwhile, the Epoxy flux merely exists at the position of the welding spot, so when the chip fails and needs to be repaired, the chip is assembled and disassembled more conveniently than the chip filled with the Underfill glue, thereby improving a success rate of repair. Meanwhile, the Epoxy Flux may be dipped on the weld leg of the chip through automatic equipment, which has better consistency and further improves the product quality in comparison with manual dispensing and semi-automatic dispensing in the Underfill process.

FIG. 3 illustrates a procedure of a method for enhancing reliability of a welding spot of a chip provided by another embodiment of the present invention. This embodiment describes a procedure of enhancing reliability of a welding spot of a bottom-layer chip in a POP process procedure or enhancing reliability of a welding spot of a chip on a PCB in a non-POP process procedure, and in this embodiment, a bonding pad is a conductor pattern at a position corresponding to a weld leg of the chip on the PCB or a conductor pattern at a position corresponding to a weld leg on a surface of the bottom-layer chip in POP packaging. The method includes the following steps:
Step 301: Print a solder paste at positions except the position corresponding to the weld leg of the chip on the PCB.

Other elements exist on the PCB in addition to the chip, so the solder paste needs to be printed for the weld legs of other elements, and in the embodiment of the present invention, an Epoxy Flux is used to complete the welding of the weld leg, so the solder paste is not printed at the position corresponding to the weld leg of the chip.

Step 302: Dip an Epoxy Flux on the weld leg of the chip or coat, with the Epoxy flux, a bonding pad corresponding to the weld leg of the chip, and mount the chip on the PCB.

This step may be performed with reference to step 301.

Step 303: Perform reflow processing on the PCB mounted with the chip, and finish curing the Epoxy flux.

The condition of curing the Epoxy flux is the same as the condition of the solder paste reflow, so the Epoxy flux may be cured at the same time when the reflow processing is performed on the PCB.

It can be seen from the above that, in this embodiment, the Epoxy Flux is used to replace a common Flux, and the Epoxy flux includes an epoxy component, so an epoxy protection layer may be formed around the welding spot after the completion of the welding. Therefore, when the welding spot suffers a mechanical impact, a mechanical stress may be eased and a mechanical strength of the welding spot may be improved. In this way, it is not required to use an Underfill process, and then it is also not required to equip Underfill devices, thereby reducing cost investment of the device, and further decreasing the process procedures and improving the manufacturing efficiency as the Underfill process does not need to be used. Meanwhile, it is merely required to form the epoxy protection layer around the welding spot, so it is merely required to use the Epoxy flux at a position of the weld leg, which belongs to a point-to-point technical solution, and may save the material and reduce the cost in comparison with the Underfill process in which Underfill glue needs to be fully filled between the bonding pad and the chip. Meanwhile, the Epoxy flux merely exists at the position of the welding spot, so when the chip fails and needs to be repaired, the chip is assembled and disassembled more conveniently than the chip filled with the Underfill glue, thereby improving a success rate of repair. Meanwhile, the Epoxy flux may be dipped on the weld leg of the chip through automatic equipment, which has better consistency and further improves the product quality in comparison with manual dispensing and semi-automatic dispensing in the Underfill process. Meanwhile, in this embodiment, the solder paste is not printed at the position corresponding to the weld leg of the chip, thereby avoiding various problems resulted from incompatibility of the solder paste and the flux.

In the embodiments of the present invention, the Epoxy Flux is dipped on the weld leg of the chip, so it is not required to print the solder paste on the bonding pad (the bottom-layer chip and the PCB in the POP process procedure, or the PCB in the non-POP process procedure), and therefore, it may be applicable to 0.5 mm bitch and 0.4 mm bitch, or 0.3 mm bitch.

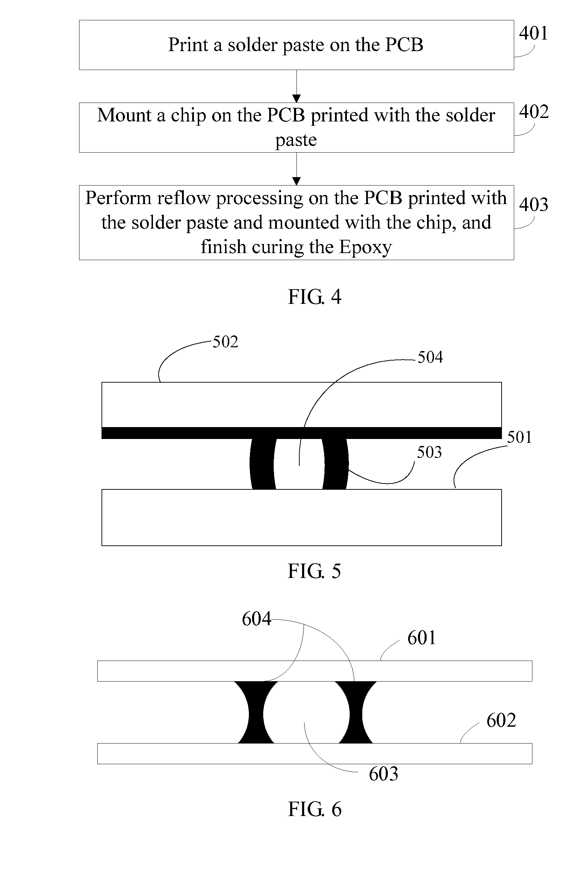

FIG. 4 illustrates a procedure of a method for enhancing reliability of a welding spot of a chip provided by another embodiment of the present invention, and this embodiment describes a procedure of enhancing reliability of a welding spot of a bottom-layer chip in a POP process procedure or enhancing reliability of a welding spot of a chip on the PCB in a non-POP process procedure, which includes the following steps:
Step 401: Print a solder paste on the PCB, where the solder paste includes an Epoxy component.

After the Epoxy component is added into the solder paste, when a solder paste is printed on the PCB, the Epoxy may be printed on the PCB.

Step 402: Mount a chip on the PCB printed with the solder paste.

The chip may be specifically a ball grid array packaging chip or a CSP chip.

Step 403: Perform reflow processing on the PCB printed with the solder paste and mounted with the chip, and finish curing the Epoxy.

The condition of curing the Epoxy is the same as the condition of the solder paste reflow, so the Epoxy may be cured at the same time when the reflow processing is performed on the PCB, and then an epoxy protection layer may be formed around the welding spot after the completion of the reflow. Therefore, when the welding spot suffers a mechanical impact, a mechanical stress may be eased and a mechanical strength of the welding spot may be improved.

FIG. 5 illustrates a structure of a welding spot of a chip on the PCB after using the technical solution provided by this embodiment. As shown in FIG. 5, a chip 502 has a welding spot 504 on a PCB 501, and an outer portion of the welding spot 504 and a lower half portion of the chip 502 are both covered by an epoxy protection layer 503.

A specific structure of the welding spot 504 is shown in FIG. 6, where the welding spot between a chip 601 and a PCB 602 includes a solder ball (solder ball) 603, and an epoxy protection layer 604 is formed on a surface of the solder ball 603.

It can be seen from the above description that, in this embodiment, an Epoxy component is added into the solder paste, and meanwhile, the condition of curing the Epoxy is the same as the condition of the solder paste reflow. Therefore, when the reflow processing is performed on the bonding pad, the Epoxy may be cured at the same time, and then an epoxy protection layer is formed around the welding spot after the completion of the reflow. In this way, when the welding spot suffers a mechanical impact, a mechanical stress may be eased and a mechanical strength of the welding spot may be improved. It is not required to use an Underfill process, and then it is also not required to equip Underfill devices, thereby reducing cost investment of the device, and further decreasing the process procedures and improving the manufacturing efficiency as the Underfill process does not need to be used.

It should be noted that, for ease of description, the above method embodiments are illustrated as a series of action combinations. However, it should be noted for persons skilled in the art that, the present invention is not limited by the described action sequence, and therefore, according to the present invention, some steps may be performed according to other sequences or performed at the same time. Moreover, it should be further noted for persons skilled in the art that, the embodiments described in the specification are exemplary embodiments, and involved actions and modules are not necessarily required in the present invention.

An embodiment of the present invention provides a printed circuit board, and the printed circuit board includes a chip, where an outer portion of a welding spot of the chip on the printed circuit board and a lower half portion of the chip are both covered by an epoxy protection layer. A structure of the welding spot is shown in FIG. 5.

Another embodiment of the present invention provides a printed circuit board, and the printed circuit board includes a chip, where a welding spot between the chip and the printed circuit board includes a solder ball and an epoxy protection layer which is formed on a surface of the solder ball. A structure of the welding spot is shown in FIG. 6.

The chip may be a ball grid array packaging chip, a chip scale packaging chip, or any chip requiring enhancement of mechanical reliability of a welding spot.

Still another embodiment of the present invention provides a printed circuit board, and the printed circuit board includes a chip, where the chip is welded on the printed circuit board through the above method for enhancing the reliability of the welding spot of the chip.

An embodiment of the present invention provides an electronic device, and the electronic device includes a printed circuit board, where the printed circuit board includes a chip, and an outer portion of a welding spot of the chip on the printed circuit board and a lower half portion of the chip are both covered by an epoxy protection layer.

Another embodiment of the present invention provides an electronic device, and the electronic device includes a printed circuit board, where the printed circuit board includes a chip, a welding spot between the chip and the printed circuit board includes a solder ball and an epoxy protection layer which is formed on a surface of the solder ball.

Still another embodiment of the present invention provides an electronic device, and the electronic device includes a printed circuit board, where the printed circuit board includes a chip, and the chip is welded on the printed circuit board through the above method for enhancing the reliability of the welding spot of the chip.

The electronic device provided by an embodiment of the present invention may be user equipment, base station equipment, a computer, a storage device or any other device requiring the printed circuit board, where the user equipment may be a cell phone, a network card, a fixed station or an access terminal and so on.

Those skilled in the art should understand that all or a part of the steps of the method according to the embodiments of the present invention may be implemented by a program instructing relevant hardware. The program may be stored in a computer readable storage medium. When the program is run, the steps of the method according to the embodiments of the present invention are performed. The storage medium may be a magnetic disk, an optical disk, a Read-Only Memory (ROM, Read-Only Memory), or a Random Access Memory (RAM, Random Access Memory).
The principle and implementation method of the present invention are described here through specific examples. The description about the embodiments of the present invention is merely provided for ease of understanding of the method and core ideas of the present invention. Persons skilled in the art may make variations and modifications to the present invention in terms of the specific implementations and application scopes according to the ideas of the present invention. Therefore, the specification shall not be construed as a limit to the present invention.

## Claims

1. A method for enhancing reliability of a welding spot of a chip, comprising:
dipping an epoxy flux on a weld leg of a chip or coating, with the epoxy flux, a bonding pad corresponding to the weld leg of the chip, and mounting the chip on the bonding pad; and
performing reflow processing on the bonding pad mounted with the chip, and finishing curing the epoxy flux.

2. The method for enhancing reliability of the welding spot of the chip according to claim 1, wherein the bonding pad is a conductor pattern at a position corresponding to the weld leg of the chip on a printed circuit board, and before the dipping the epoxy flux on the weld leg of the chip or coating, with the epoxy flux, the bonding pad corresponding to the chip, the method further comprises:
printing a solder paste at a position except a position corresponding to the weld leg of the chip on the printed circuit board.

3. The method for enhancing reliability of the welding spot of the chip according to claim 1, wherein the bonding pad is a conductor pattern at a position corresponding to a weld leg on a surface of a bottom-layer chip in a package on package assembly.

4. The method for enhancing reliability of the welding spot of the chip according to any one of claims 1 to 3, wherein the epoxy flux is dipped on the weld leg of the chip through a dipping manner, or the bonding pad corresponding to the weld leg of the chip is coated with the epoxy flux through a jetting manner, or the bonding pad corresponding to the weld leg of the chip is coated with the epoxy flux through a dispensing manner.

5. The method for enhancing reliability of the welding spot of the chip according to claims 1 to 3, wherein the chip is a ball grid array packaging chip, a chip scale packaging chip, or any chip requiring enhancement of mechanical reliability of the welding spot.

6. A method for enhancing reliability of a welding spot of a chip, comprising:
printing a solder paste on a printed circuit board, wherein the solder paste comprises an epoxy component;
mounting a chip on the printed circuit board which is printed with the solder paste; and
performing reflow processing on the printed circuit board which is printed with the solder paste and mounted with the chip, and finishing curing the epoxy.

7. The method for enhancing reliability of the welding spot of the chip according to claim 6, wherein the chip is a ball grid array packaging chip, a chip scale packaging chip, or any chip requiring enhancement of mechanical reliability of the welding spot.

8. A printed circuit board, comprising a chip, wherein an outer portion of a welding spot of the chip on the printed circuit board and a lower half portion of the chip are both covered by an epoxy protection layer.

9. A printed circuit board, comprising a chip, wherein a welding spot between the chip and the printed circuit board comprises a solder ball and an epoxy protection layer which is formed on a surface of the solder ball.

10. A printed circuit board, comprising a chip, wherein the chip is welded on the printed circuit board through the method according to any one of claims 1 to 5.

11. A printed circuit board, comprising a chip and a bonding pad, wherein the chip is welded on the printed circuit board through the method according to claim 6 or 7.

12. An electronic device, comprising a printed circuit board, wherein the printed circuit board comprises a chip, and an outer portion of a welding spot of the chip on the printed circuit board and a lower half portion of the chip are both covered by an epoxy protection layer.

13. An electronic device, comprising a printed circuit board, wherein the printed circuit board comprises a chip, a welding spot between the chip and the printed circuit board comprises a solder ball and an epoxy protection layer which is formed on a surface of the solder ball.

14. An electronic device, comprising a printed circuit board, wherein the printed circuit board comprises a chip, and the chip is welded on the printed circuit board through the method according to any one of claims 1 to 5.

15. An electronic device, comprising a printed circuit board, wherein the printed circuit board comprises a chip, and the chip is welded on the printed circuit board through the method according to claim 6 or 7.
